# EUROPÄISCHE PATENTSCHRIFT

(11) **EP 0 387 854 B1**
(45) Veröffentlichungstag und Bekanntmachung des Hinweises auf die Patenterteilung: **15.10.2003**
(21) Anmeldenummer: 90104847.0
(22) Anmeldetag: 14.03.1990
(51) Int. Cl.: H01L 27/22

(54) **Vorrichtung zur kontaktlosen Sollwertvorgabe für einen mit nichtmagnetischen Werkstoff umhüllten integrierten Schaltkreis**
Device for a contactless setting of a target value for an integrated circuit enveloped by a non-magnetic material
Dispositif pour établir sans contact le point de consigne d'un circuit intégré recouvert par un matériau non magnétique

(30) Priorität: 17.03.1989 DE 3908892
(43) Veröffentlichungstag der Anmeldung: 19.09.1990
(73) Patentinhaber: Infineon Technologies AG, 81669 München (DE)
(72) Erfinder: Lachmann, Ulrich, D-8000 München 70 (DE)

(56) Entgegenhaltungen:
- US-A- 3 596 114
- PATENT ABSTRACTS OF JAPAN vol. 7, no. 272 (E-214)(1417) 03 Dezember 1983, & JP-A-58 154264 (SHARP K.K.) 13 September 1983,
- Brockhaus Naturwissenschaften und Technik, Wiesbaden 1983, Band3, Seiten 208,209,216 and 217

## Beschreibung

Die Erfindung betrifft eine Vorrichtung zur kontaktlosen Sollwertvorgabe für einen mit nichtmagnetischem Werkstoff umhüllten integrierten Schaltkreis.

Es sind zahlreiche integrierte Schaltkreise bekannt, denen über externe, leitungsgebundene Betätigungselemente funktionswichtige Sollwerte vorgegeben werden. Bevorzugt finden als externe Betätigungselemente Potentiometer Verwendung, welche eine gut handhabbare und genaue Einstellung des Sollwertes ermöglichen. Übliche Anwendungen von Potentiometern in Verbindung mit integrierten Schaltkreisen sind beispielsweise Lautstärkesteller bei Niederfrequenzverstärkern, Ist-Wert-Potentiometer bei Nachlaufsteuerungen oder Stellpotentiometer. bei Dimmerschaltungen.

Nachteile beim Einsatz von Potentiometern sind jedoch u. a. der Bedarf an zusätzlichen Anschlüssen des integrierten Schaltkreises sowie mechanischer Verschleiß der Potentiometer durch Abnutzung des Schleifers und der Widerstandsbahn. Des weiteren wird die Zuverlässigkeit der Potentiometer bei ungünstigen Betriebsbedingungen wie etwa durch Feuchtigkeit, Staub oder mechanischen Einwirkungen beispielsweise bei Betrieb in einem Kraftfahrzeug stark herabgesetzt. Abhilfe brachten hier bisher nur aufwendige Sonderbauformen.

Aus US 3,596,114 ist eine Schaltungsanordnung und ein Hall-Effekt-Element bekannt, die in einem Halbleiterkörper integriert sind. Das Hall-Effekt-Element liefert in Abhängigkeit von der Positionierung eines Ferrites ein Steuersignal, welches der integrierten Schaltung zugeführt wird.

Aufgabe der Erfindung ist es, eine Vorrichtung zur Sollwertvorgabe für einen integrierten Schaltkreis mit geringerer Störanfällikeit bei geringerem Aufwand anzugeben.

Die vorstehend aufgezeigte Aufgabe wird mit einer Vorrichtung durch die kennzeichnenden Merkmale des Patentanspruchs 1 gelöst. Ausgestaltungen des Erfindungsgedankens sind in Unteransprüchen gekennzeichnet.

Vorteil der Erfindung ist es, daß ohne Zusatzschritte Hall-Sensoren in einen gegebenen integrierten Schaltkreis bei dessen Herstellung mitintegriert werden können. Es werden darüber hinaus keine zusätzlichen Anschlüsse für externe Betätigungselemente benötigt. Das erfindungsgemäß vorgesehene Betätigungselement, nämlich ein drehbarer, ringförmiger Permanentmagnet mit Spalt, ist zudem mit geringem Aufwand herstellbar und außerdem nicht elektrisch mit der integrierten Schaltung verbunden, wodurch Kontaktschwierigkeiten am Betätigungselement ausgeschlossen sind und eine hohe elektrische Isolation in Verbindung mit der Umhüllung erreicht werden kann. Aber auch der Einfluß von Staub, Feuchtigkeit und mechanischen Erschütterungen wird dadurch gering gehalten.

Die Erfindung wird nachfolgend anhand der Zeichnung näher erläutert. Es zeigen
- Figur 1: eine nicht erfindungsgemäße Vorrichtung mit zwei Hall-Sensoren und einem parallel dazu verschiebbaren Permanentmagneten,
- Figur 2: eine nicht erfindungsgemäße Vorrichtung mit einem Hall-Sensor und einem senkrecht zur Sensorfläche verschiebbaren Permanentmagneten und
- Figur 3: ein Ausführungsbeispiel einer erfindungsgemäßen Vorrichtung mit einem Hall-Sensor und einem ringförmigen Permanentmagneten.

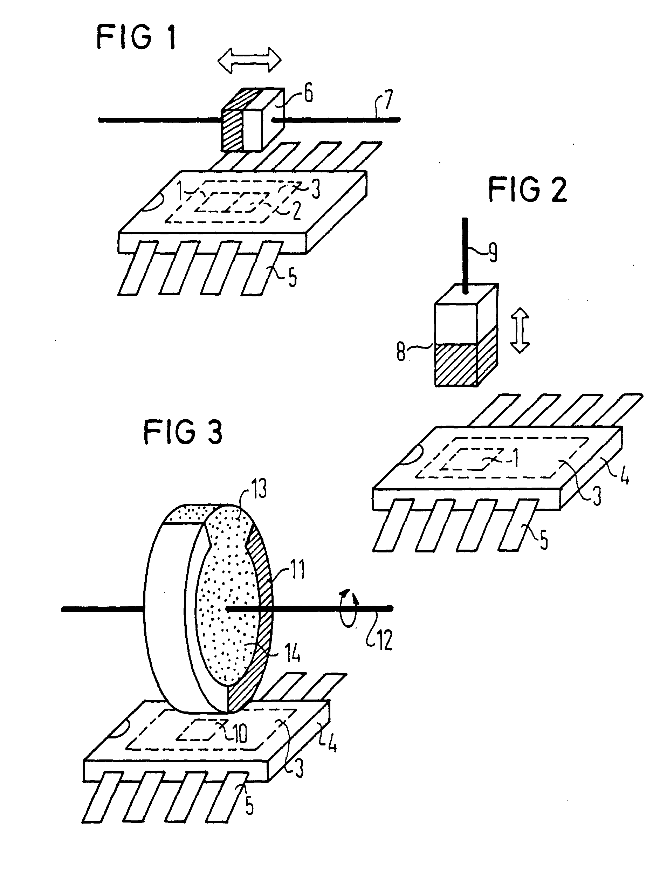

Bei der Vorrichtung gemäß Figur 1 sind zwei Hall-Sensoren 1, 2 in einem integrierten Schaltkreis 3 in unmittelbarer Nähe zueinander mitintegriert. Der integrierte Schaltkreis 3 ist völlig mit nichtmagnetischem Werkstoff 4, beispielsweise Kunststoff umhüllt und weist Anschlüsse 5 zum Kontaktieren auf. Parallel zur Sensorfläche ist über dem integrierten Schaltkreis 3 ein Permanentmagnet 6 auf einer Achse 7 derart angeordnet, daß dieser an den beiden Hall-Sensoren 1, 2 vorbeibewegt werden kann. Dabei kann je nach Anwendungsfall der Permanentmagnet 6 entweder starr mit der Achse 7 verbunden oder auf der Achse 7 verschiebbar sein. Bei verschiedenen Positionen des Permanent 6 ist die Stärke und die Polarität des einfallenden Magnetfeldes unterschiedlich und somit auch jeweils das von den Hall-Sensoren 1, 2 bei der entsprechenden Position abgegebene Signal. Bevorzugt werden die beiden Hall-Sensoren 1, 2 in Differenzschaltungen betrieben, um störende auf beide Hall-Sensoren 1, 2 gleichmäßig einwirkende Störfelder zu unterdrücken.

Gemäß Figur 2 enthält der integrierte Schaltkreis 3 einen Hall-Sensor 10. Ein Permanentmagnet 8 ist auf einer sich senkrecht zur Sensorfläche befindlichen Achse 9 je nach Anwendungsfall starr oder verschiebbar angeordnet. Das Verschieben des Permanentmagneten 8 erfolgt wie auch bei dem Permanentmagneten 6 der Vorrichtung nach Figur 1 entlang der Achse 7 bzw. 9. Dabei kann ein Verschieben des Permanentmagneten 8, 6 entweder durch direkte Krafteinwirkung auf den Magneten bei einer losen Verbindung zwischen Permanentmagneten 8, 6 und Achse 9, 7 oder durch Kraftübertragung durch die Achse 9, 7 bei einer festen Verbindung erfolgen.

Gegenüber Figur 2 ist das erfindungsgemäße Ausführungsbeispiel nach Figur 3 dahingehend abgeändert, daß auf einer Achse 12, die parallel zur Sensorfläche verläuft, befestigt und gegenüber der Achse 12 drehbar ein ringförmiger Permanentmagnet 11 angeordnet ist. Der ringförmige Permanentmagnet 11 weist einen Spalt 13 auf.

Der Spalt 13 ist ebenso wie der gesamte vom ringförmigen Magneten 11 umgebene Innenraum mit nichtmagnetischem Werkstoff 14, beispielsweise Kunststoff, ausgefüllt. Bei dem nichtmagnetischen Werkstoff 14 ist etwa im Ringmittelpunkt eine Bohrung zum Aufbringen auf die Achse 12 vorgesehen. Die beiden Pole des ringförmigen Magneten 11 sind dabei so angeordnet, daß sie sich in dem Spalt 13 gegenüberstehen. Beim Drehen des Permanentmagneten 11 bei einer losen Verbindung oder durch Drehen der Achse 12 bei einer festen Verbindung nimmt der Permanentmagnet 11 Stellungen ein, in denen Polarität und Stärke des einwirkenden Magnetfeldes unterschiedlich sind und somit im Hall-Sensor 10 ein Signal mit unterschiedlicher Polarität und Stärke erzeugt wird. Beispielsweise ist in der Nähe der Nahtstelle zwischen beeiden Polen das auftretende Magnetfeld etwa gleich Null, während es an den Polen selbst mit der entsprechenden Polarität betragsmäßig maximal ist.

Neben den bereits genannten Vorteilen wie hohe elektrische Isolation, geringer Aufwand und Unempfindlichkeit gegenüber äußeren Einwirkungen zeichnen sich erfindungsgemäße Schaltungsanordnungen und Vorrichtungen durch eine hohe Anpaßfähigkeit an den jeweiligen Verwendungszweck aus.

## Patentansprüche

1. Vorrichtung zur Kontaktlosen Sollwertvorgabe für die Steuerung wertekontinuierlicher Größen mit
einem integrierten Schaltkreis (3), der sich innerhalb einer Umhüllung aus nichtmagnetischem Werkstoff (4) befindet,
einem in den integrierten Schaltkreis (3) mitintegrierten und mit weiteren Teilen des integrierten Schaltkreises (3) in Verbindung stehenden Hall-Sensor (1, 2) und
einem auf den Hall-Sensor (1, 2) magnetisch einwirkenden, außerhalb der Umhüllung angeordneten und in der Position relativ zum Hall-Sensor (1, 2) veränderbaren Permanentmagneten (6, 8, 11 ), wobei die Stärke des einfallenden Magnetfeldes und damit auch die Stärke des von dem Hall-Sensor (1, 2) abgegebenen Signals unterschiedlich ist und wobei ein drehbarer, ringförmiger Permanentmagnet mit Spalt (13) vorgesehen ist.

2. Vorrichtung nach Anspruch 1, bei dem
mehrere Hall-Sensoren (1, 2) in den integrierten Schaltkreis (3) mitintegriert sind.

3. Vorrichtung nach Anspruch 2, bei dem
zwei Hall-Sensoren (1, 2) in Differenzschaltung betrieben werden.

## Claims

1. A device for the contact less presetting of a set value for the control of continuous-value variables having an integrated circuit (3), which is situated inside a case made from a non-magnetic material (4), a Hall sensor (1, 2) also integrated in the integrated circuit (3) and connected to further parts of the integrated circuit (3) and a permanent magnet (6, 8, 11) which acts magnetically on the Hall sensor (1, 2), is disposed outside the case and whose position can be changed in relation to the Hall sensor(1, 2), where the strength of the incident magnetic field and thus also the strength of the signal emitted by the Hall sensor (1, 2) is different and where a rotatable, annular permanent magnet with a gap (13) is provided.

2. A device according to Claim 1, in which several Hall sensors (1, 2) are also integrated in the integrated circuit (3).

3. A device according to Claim 2, in which two Hall sensors (1, 2) are operated in a differential circuit.

## Revendications

1. Dispositif pour établir sans contact une valeur de consigne pour commander des valeurs continues, avec un circuit intégré (3) qui se trouve à l'intérieur d'une gaine en un matériau non magnétique (4), avec un capteur à effet Hall (1, 2) intégré dans le circuit intégré (3) et ayant une liaison avec d'autres parties du circuit intégré (3) et
avec un aimant permanent (6, 8, 11) qui agit magnétiquement sur les capteurs à effet Hall (1, 2), qui est placé à l'extérieur de la gaine et dont on peut modifier la position par rapport au capteur à effet Hall (1, 2), pour lequel l'intensité du champ magnétique incident et donc aussi l'intensité du signal émis par le capteur à effet Hall (1, 2) sont variables et pour lequel on prévoit un aimant permanent annulaire et rotatif avec un entrefer (13).

2. Dispositif selon la revendication 1,
pour lequel plusieurs capteurs à effet Hall (1, 2) sont intégrés dans le circuit intégré (3).

3. Dispositif selon la revendication 2,
pour lequel fonctionnent deux capteurs à effet Hall (1, 2) dans des circuits différentiels.
